**Europäisches Patentamt**

**European Patent Office**

**Office européen des brevets**

(19)

(11) Veröffentlichungsnummer: **0 265 423**
**B1**

(12) EUROPÄISCHE PATENTSCHRIFT

(45) Veröffentlichungstag der Patentschrift: **01.08.90**

(51) Int. Cl.⁵: **A 47 F 7/024**

(21) Anmeldenummer: **86901054.6**

(22) Anmeldetag: **23.01.86**

(86) Internationale Anmeldenummer:
**PCT/EP86/00025**

(87) Internationale Veröffentlichungsnummer:
**WO 86/04796 28.08.86 Gazette 86/19**

(54) **PRÄSENTATIONSTABLEAU.**

(30) Priorität: **21.02.85 DE 8510187 u**

(43) Veröffentlichungstag der Anmeldung:
**04.05.88 Patentblatt 88/18**

(45) Bekanntmachung des Hinweises auf die
Patenterteilung:
**01.08.90 Patentblatt 90/31**

(84) Benannte Vertragsstaaten:
**AT BE CH DE FR GB IT LI LU NL SE**

(56) Entgegenhaltungen:
**CH-A- 594 390**
**DE-A-2 603 518**
**FR-A-2 399 225**
**US-A-4 073 557**

(73) Patentinhaber: **Citizen Europe
Uhrenhandelsgesellschaft mbh
Horner Landstrasse 302-304
D-2000 Hamburg 74 (DE)**

(72) Erfinder: **TRISL, Klaus
Franz-Abt-Strasse 10
D-6200 Wiesbaden (DE)**

(74) Vertreter: **Stoffregen, Hans-Herbert, Dr. Dipl.-
Phys. et al
Patentanwälte Strasse & Stoffregen Salzstrasse
11a Postfach 2144
D-6450 Hanau/Main 1 (DE)**

## Beschreibung

### Stand der Technik

Die Erfindung bezieht sich auf einen Präsentationskasten in Form eines Präsentationstableaus mit einer Präsentationsfläche zum offenen Anbieten von Gegenständen, wie insbesondere Uhren, mit Halterungen die zumindest in eine von der Präsentationsfläche ausgehende Ausnehmung einbringbar ist, wobei die Gegenstände lösbar mit den Halterungen verbunden sind, die ihrerseits bei in den Ausnehmungen eingebrachter Positionierung gegen ein unkontrolliertes Entfernen dadurch gesichert sind, daß in von den Halterungen ausgehendem Abschnitt eine Sicherung eingreift, und wobei die Sicherung zumindest ein Schiebeelement ist, das parallel oder in etwa parallel zu dem Boden des Präsentationskastens derart verschiebbar ist, daß es wahlweise den Abschnitt zumindest bereichsweise erfaßt.

Heutzutage ist es erforderlich, Waren möglichst umfassend den Interessenten anzubieten, ohne daß notwendigerweise die Anzahl des Bedienungspersonals zunimmt. Daher ist es insbesondere bei kleineren, jedoch wertvollen Gegenständen erforderlich, daß diese gegen Diebstahl gesichert sind. So gibt es bereits Glasvitrinen, hinter denen Uhren oder ähliches ausgestellt werden. Glasvitrinen haben jedoch den Nachteil, daß diese relativ sehr teuer sind. Zudem müssen die Glasflächen sehr häufig gereinigt werden, da anderenfalls die Vitrinen unansehlich werden. Nachteilig ist ferner, daß der Kunde die derart ausgestellten Waren nicht unmittelbar berühren kann, ein Erfordernis, das für einen Kaufentschluß positiv ist. Zwar besteht die Möglichkeit, insbesondere Uhren über Ketten eine unkontrollierte Entnahme aus Präsentationskästen oder ähnliches zu sichern. Eine solche Handhabung ist jedoch nicht nur umständlich, sondern vermittelt gegenüber den Interessenten ein Mißtrauen, das vermieden werden muß.

Der CH—A—594 390 ist ein Präsentationskasten der eingangs beschriebenen Art zu entnehmen, in dem Armbanduhren ihrer Länge nach auf jeweils einer Halterung gelegt und mit diesen über Haken befestigt werden. Durch die Art der Präsentation der Uhren wird eine große Fläche benötigt, wobei die Sicherung der Uhren an den Halterungen risikobehaftet ist, da ein unkontrolliertes Entfernen der Uhr von der Halterung möglich ist. In der DE—A—26 03 518 ist ein Schmuckkasten mit Einsteckschlitzen zum Befestigen von insbesondere Ringen offenbart, durch die Sperriegel schiebbar sind.

### Aufgabe der Erfindung

Aufgabe der vorliegenden Erfindung ist es, einen Präsentationskasten der zuvor beschriebenen Art so auszubilden, daß Gegenstände wie insbedsondere Uhren offen angeboten werden können und gegen eine unkontrollierte Entnahme gesichert sind, ohne daß dies für den Interessenten wahrnehmbar ist, zudem sollen möglichst viele Gegenstände auf kleiner Fläche präsentiert werden können.

Die Aufgabe wird dadurch gelöst, daß für jede Halterung eine gesonderte von der Präsentationsfläche ausgehende Ausnehmung vorhanden ist, daß jede Halterung zwei zueinander beabstandete von der Rückseite der für einen Gegenstand bestimmten Haltefläche oder von dessen Seitenrändern ausgehende Abschnitte aufweist, daß der Gegenstand auf der Haltefläche und zwischen den von dieser bzw. deren Seitenrändern ausgehenden Abschnitten derart verläuft, daß bei in der Ausnehmung eingebrachter Halterung der Gegenstand von dieser nicht entfernbar ist, und daß jede Ausnehmung zumindest an einer ihrer Innenseiten eine für die einzubringende Halterung bestimmte Führung aufweist, in die einer der beiden von der Haltefläche oder deren Seitenrändern ausgehenden Abschnitte der Halterung geführt ist. Vorzugsweise weist der mit dem Schiebeelement wechselwirkende Abschnitt in seinen Seitenrändern Einkerbungen auf, in die wahlweise das Schiebeelement derart eingreift, daß die Halterung lösbar oder diebstahlgesichert ist. Das Schiebeelement, das auch als Verriegelungselement zu bezeichnen ist, wird nach einer besonders hervorzuhebenden Ausgestaltung der Erfindung in einem plattenförmigen entlang des Bodens des Präsentationskastens verschiebbaren Element eingelassen.

So sind pro Verschiebe- oder Verriegelungselement in dem plattenförmigen Element zwei ineinander übergehende Aussparungen vorgesehen, wobei zum einen der Übergangsbereich zwischen den Aussparungen und zum anderen ein Randbereich von diesen dit mit den Einkerbungen in den Schenkeln wechselwirkenden Vorsprünge bilden. Demzufolge sind die Breiten der einzelnen Aussparungen außerhalb der Vorsprünge größer gewählt als die der Schenkel. In entriegelter Position befinden sich die freien Enden der Schenkel innerhalb der Aussparungen, ohne von diesen behindert zu werden. In gesicherter Stellung greifen dagegen die Vorsprünge des Schiebe- bzw. Verriegelungselementes in die Einkerbungen ein, so daß die Halterung aus dem Präsentationstableau nicht herausgenommen werden kann.

Bei dem erfindungsgemäß ausgebildeten Präsentationskasten ist die diebstahlhemmende Sicherung nicht ohne weiteres wahrnehmbar, so daß gegenüber einem Kunden ein Mißtrauen nicht offen dargelegt wird. Entsprechend ausgebildete Präsentationskasten können auch zu Säulen oder Wänden zusammengestellt werden, wodurch eine große Verkaufsfläche zur Verfügung gestellt wird, ohne daß zur Überwachung eine große Anzahl von Verkäufern erforderlich ist. Demzufolge wird durch die erfindungsgemäße Lehre zusätzlich der Vorteil erzielt, daß, ohne die Anzahl des Bedienungspersonals zu erhöhen, im Vergleich zu bekannten Präsentationen mehr Gegenstände wie z.B. Uhren ausgestellt und damit angeboten werden können.

Auch besteht die Möglichkeit, den erfindungsgemäßen Präsentationskasten zu prismenförmigen Säulen zusammenzusetzen, die um ihre Längsachse drehbar sind. Dadurch ergibt sich z.B. bei einer sichtbaren Fläche von einem Quadratmeter eine effektive Präsentationsfläche von drei Quadratmetern, wodurch weiderum die Anzahl der angebotenen Gegenstände im Vergleich zu bekannten Anordnungen erhöht wird.

Die Halterung für z.B. eine Uhr kann übliche Gestalt aufweisen, also Spangenform besitzen, wobei von den Randbereichen des mittleren Teils der Spange die erwähnten Abschnitte parallel zueinander verlaufend ausgehen. Demzufolge zeigt die in den erfindungsgemäßen Präsentationskasten eingebrachte Halterung in Seitenansicht in etwa eine T-Form auf, wobei die Enden der Querschenkel in Richtung des Mittelschenkels umgebogen sind, die selbst die in die Führung einbringbaren schenkelförmigen Abschnitte sind.

Auf eine eigenständige Ausgestaltung der Erfindung hinsichtlich der Führungen und der in diese einschiebbaren Schenkel sei nachdrücklich verwiesen, durch die sichergestellt ist, daß bei in den Kasten eingebrachten, jedoch noch nicht verriegelten Halterungen ein ungewolltes Herausfallen nicht erfolgen kann. So weisen die Bodenflächen der für die Halterungen bestimmten Ausnehmungen des Tableau schlitzförmige Aussparungen auf, in die bei eingesetzter Halterung die freien Enden der parallel zueinander verlaufenden Schenkel hineinragen, so daß diese nicht aufeinanderzu bewegt werden können. Ferner weisen die Schenkel jeweils eine Verstärkung wie z.B. eine Wulst auf, die sich in Richtung einer in der anliegenden Seitenwandung vorhandenen Ausnehmung erstreckt. Hierdurch erfolgt eine zusätzliche Sicherung und damit ein Festlegen der Halterung, so daß ein ungewolltes Verrutschen oder sogar Herausfallen aus dem Tableau ausgeschlossen ist. Sofern das Schiebeelement durch das stabförmige Element gebildet wird, durchsetzt dessen freies Ende den Schenkel innerhalb der Verstärkung.

Ausgestaltungen der Erfindung ergeben sich aus den Ansprüchen.

Beschreibung bevorzugter Ausführungsbeispiele

Weitere Einzelheiten, Vorteile und Merkmale der Erfindung ergeben sich ferner aus der nachfolgenden Beschreibung von in der Zeichnung dargestellten bevorzugten Ausführungsbeispielen.

Es zeigen:

Fig. 1 eine perspektivische Darstellung eines erfindungsgemäßen Präsentationskasten,

Fig. 2 eine Draufsicht des Präsentationskasten nach Fig. 1 im Schnitt,

Fig. 3 eine Schnittdarstellung entlang der Linie III/III in Fig. 2,

Fig. 4 eine Schnittdarstellung entlang der Linie IV/IV in Fig. 2,

Fig. 5 eine Seitenansicht einer in den Präsentationskasten einbringbaren Halterung,

Fig. 6 eine perspektivische Darstellung der Bodenplatte des Präsentationskastens nach Fig. 1,

Fig. 7 eine Detaildarstellung eines Schiebeelementes,

Fig. 8 mehrere der Fig. 1 entsprechende Präsentationskästen zusammengestellt zu einer Säule,

Fig. 9 mehrere der Fig. 1 zu entnehmende Präsentationskästen zusammengestellt zu einer Wand und

Fig. 10 zu drehbar ausgebildeten Prismensäulen zusammengestellte Präsentationskästen gemäß Fig. 1,

Fig. 11 eine weitere Anordnung von zu Ausstellungswänden zusammengestellten Präsentationstableaux,

Fig. 12 eine Explosionsdarstellung einer besonders hervorzuhebenden Ausgestaltung eines Präsentationstableau,

Fig. 13 eine Draufsicht des Präsentationstableau nach Fig. 12 und

Fig. 14 eine Schnittdarstellung entlang der Linie XIV—XIV in Fig. 13.

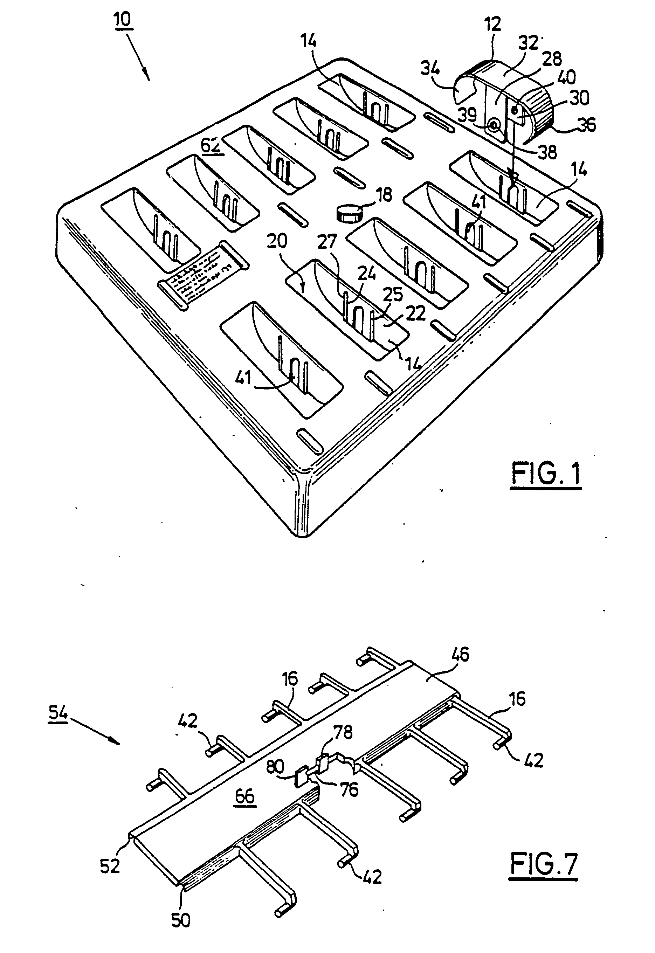

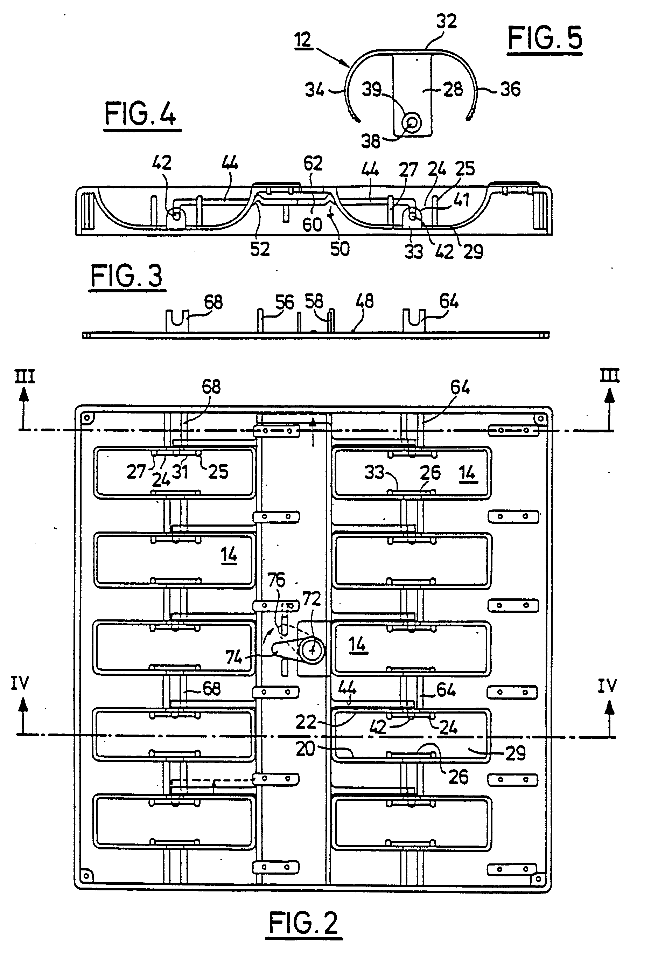

In Fig. 1 wird in perspektivischer Darstellung ein erfindungsgemäßes Präsentationstableau (-kasten) 10 dargestellt, das dazu bestimmt ist, diebstahlgesichert Uhren aufzunehmen, die ihrerseits eine Halterung 12 umgeben. Die Halterungen 12 werden in in dem Präsentationstableau 10 vorhandene Ausnehmungen 14 gesichert aufgenommen, wie insbesondere anhand der Fig. 2 bis 6 näher erläutert werden soll.

Das Präsentationstableau 10 weist vorzugsweise Quaderform auf und besitzt im Ausführungsbeispiel insgesamt zehn für Uhren bzw. Halterungen 12 bestimmte Ausnehmungen 14. Jeder Ausnehmung 14 kann eine austauschbare Beschriftung zugeordnet werden. Dabei kann es sich um Preisschilder oder auch technische Beschreibungen handeln. Ferner erkennt man, daß im Mittenbereich des Präsentationstableau eine Schloßöffnung 18 vorgesehen ist, um ein Verschlußelement zu betätigen, über das die in die Ausnehmungen 14 eingebrachten Halterungen 12 verriegelt werden können.

Hierzu weisen die Ausnehmungen 14 an den Längsseiten 20 bzw. 22 Führungen 24 bzw. 26 auf, die von parallel zueinander verlaufenden Stegen 25, 27 begrenzt sind und in die parallel zueinander verlaufende Schenkel 28 bzw. 30 der Halterung 12 einbringbar sind. In der Bodenfläche 29 der Ausnehmungen 14 befindet sich jeweils unterhalb der Führung 24 bzw. 26 eine schlitzförmige Aussparung 31 bzw. 33, in das das freie Ende des Schenkels 28 bzw. 30 bei in das Tableau 10 eingebrachter Halterung 12 eingreift. Dadurch ist sichergestellt, daß dann die Schenkel 28, 30 nicht aufeinanderzu bewegt werden können. Ferner sind die Löcher 38, 40 der Schenkel 28, 30 von einer Wulst 39 umgeben, die ihrerseits bei in die Ausnehmung 14 eingebrachter Halterung 12 mit in der Innenwandung 20, 22 innerhalb der Führung 24, 26 vorhandener Aussparung 41 wechselwirkt, d.h. in diese eingreift, wodurch ein unkontrolliertes Herausrutschen der Halterung 12 ausgeschlossen ist. In diesen zuvor geschilderten zusätzlichen Sicherungsmaßnahmen für die Halterung 12 ist eine selbständig schutzfähige Ausgestaltung der Erfindung zu sehen.

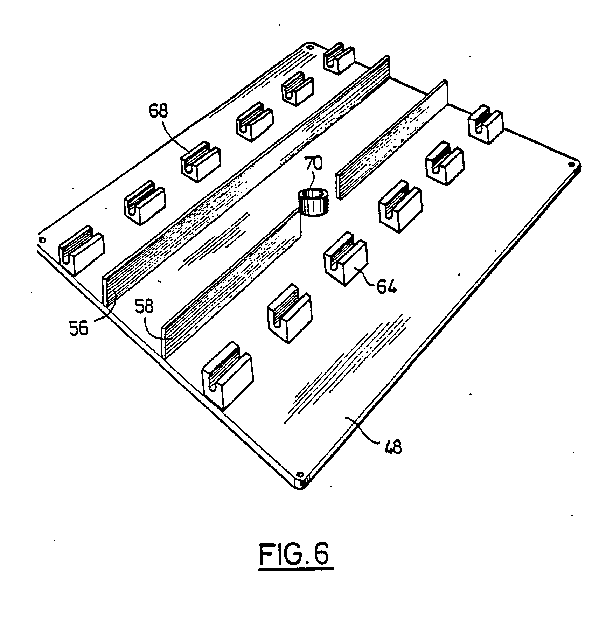

Die Schenkel 28 und 30 gehen vorzugsweise von dem Mittenbereich einer Auflagefläche 32 der Halterung 12 aus, die selbst in Seitenansicht (Fig. 5) eine T-Form mit in Richtung der Schenkel 28, 30 umgebogenen Endabschnitten 34 bzw. 36 aufweist. Mit anderen Worten setzt sich die Halterung 12 aus einem spangenförmigen Grundkörper bekannter Gestalt zusammen, der von einer Uhr mit Armband umgeben ist. Zusätzlich gehen jedoch von dem spangenförmigen Grundelement die Schenkel 28 und 30 aus, die in bezug auf die zugeordnete Ausnehmung 14 so ausgebildet sind, daß sie in die Führungen 24 und 26 eingeschoben werden können (siehe Pfeil in Fig. 1). Im Endbereich der Schenkel 28 und 30 befinden sich Aussparungen wie Löcher 38 und 40, von denen eines von einem freien Ende 42 eines stabförmigen Elementes 16 durchsetzt ist. Dieses stabförmige Element 16 geht von einer Grundplatte 46 aus, die innerhalb des Präsentationstableau 10 und parallel zu dessen Bodenplatte 48 derart verschiebbar ist, daß die freien Enden 42 der stabförmigen Elemente 16 wahlweise mit einem der Ausnehmungen 38, 40 der Schenkel 28, 30 von Halterung 12 wechselwirken. Mit anderen Worten wird durch die Stellung der Grundplatte 46 und damit der freien Enden 42 bestimmt, ob die Halterungen 12 mit den diese umgebenden Uhren aus dem Präsentationstableau 10 entfernt werden können oder nicht. Die stabförmigen die Sicherung der Halterungen 12 bietenden Elemente 16 bilden zusammen mit der Grundplatte 46 ein Schiebeelement 54, das in Längsrichtung verlaufende nutenförmige Aussparungen 50, 52 aufweist, in die in Längsrichtung der Bodenplatte 48 verlaufende Stege 56 und 58 eingreifen. Dadurch ist die Führung des Schiebeelementes 54 in dessen Längsrichtung gewährleistet. Um ein Bewegen senkrecht hierzu zu verhindern, gelangt die Grundplatte 46 zumindest abschnittsweise mit der Innenfläche 60 der Oberseite 62 des Präsentationsgehäuses in Berührung. Vorzugsweise geschieht dies im Bereich der nutenförmigen Längsaussparung 50 und 52, deren freie obere Seiten über der Oberfläche 66 der Grundplatte 46 hervorragen.

Die freien Enden 42 der stabförmigen Elemente 16, die auch als Finger bezeichnet werden können, verlaufen parallel zur Verschieberichtung des Schiebeelementes 54, um so kontrolliert die zugeordnete Aussparung 38 bzw. 40 des Schenkels 28 bzw. 30 der Halterung 12 zu durchsetzen bzw. aus dieser entfernt zu werden. Um insoweit dem Schiebeelement 54 und der Bewegung eine zusätzliche Stabilität zu geben, werden die freien Enden 42 der Finger (16) in Lagerelementen 64 bzw. 68 geführt, die von der Bodenplatte 48 ausgehen. Damit die Bewegung nicht durch die senkrecht zur Verschieberichtung verlaufenden Abschnitte 44 der von der Grundplatte 46 abragenden Finger 16 behindert wird, ist der Endabschnitt 42 zu dem senkrecht hierzu verlaufenden Abschnitt 44 in Richtung der Bodenplatte 48 versetzt angeordnet. Mit anderen Worten bestehen die die Verriegelung der Halterung 12 sicherstellenden Finger 16 aus zwei einen rechten Winkel zueinander beschreibenden Abschnitten 42 und 44, zwischen denen eine Stufe ausgebildet ist.

Im Bereich des Stegs 58 befindet sich eine Aussparung, in der ein Gegenlager 70 zur Aufnahme des Verschlußelementes 72 angeordnet ist. Das Verschlußelement 72 weist seinerseits einen vorspringenden Zapfen 74 aus, der in eine Aussparung 76 eingreift, die durch zueinander beabstandete von der Oberfläche 66 der Grundplatte 46 abragende Vorsprünge 78 und 80 gebildet ist. Durch Drehen (durchgezogene und gestrichelte Darstellung) des Zapfens 74 (Fig. 2) kann das Schiebeelement 54 entlang der Stege 56 und 58 bewegt werden, wodurch ein Zusammenwirken oder in Ausgriffgelangen der freien Enden 42 der Finger 16 mit den Halterungen 12 bzw. der von diesen abragenden Schenkel 28 bzw. 30 erfolgt.

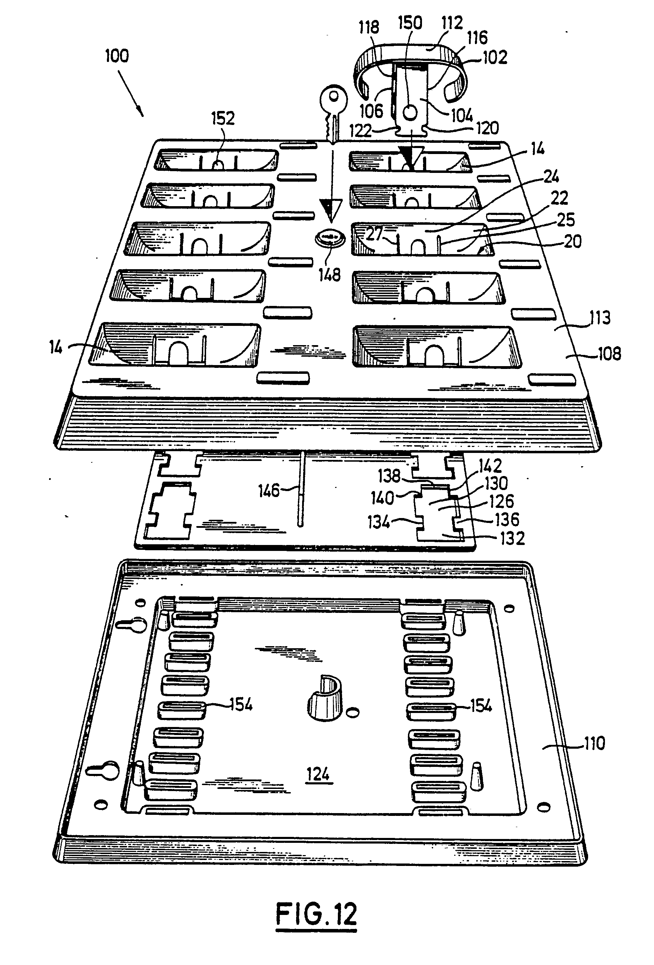

Den Fig. 12 bis 14 sind besonders hervorzuhebende Ausgestaltungen eines Präsentationstableau 100 zu entnehmen, das dem Aufbau des in den Fig. 1 bis 7 beschriebenen grundsätzlich entspricht. Daher wurden auch gleiche Elemente mit gleichen Bezugszeichen versehen.

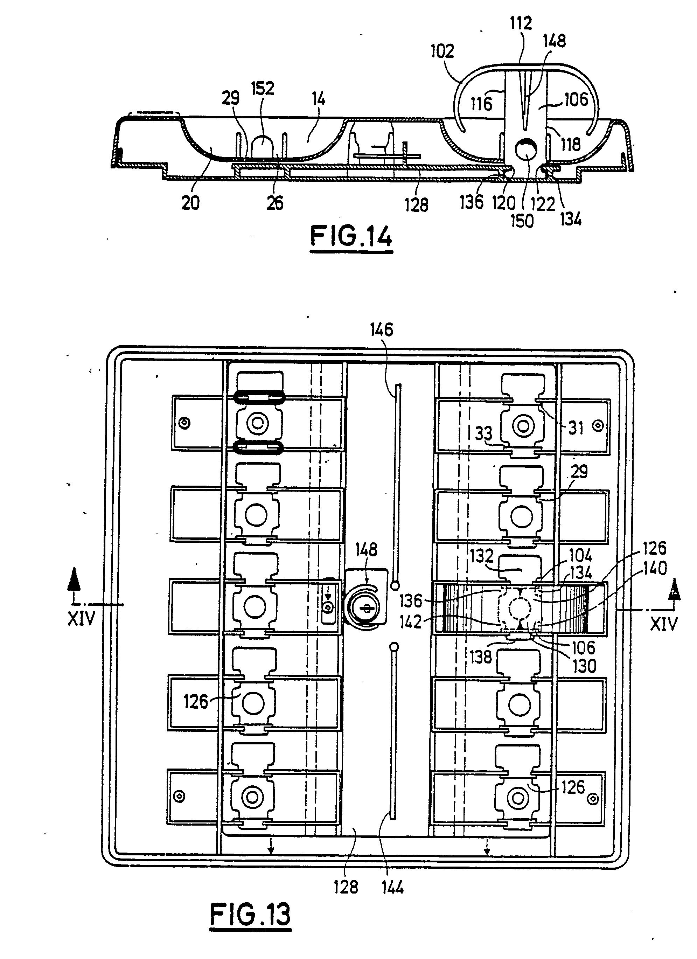

Der Tableau 100 besteht aus einem Oberteil 108, das z.B. mittels Schrauben mit einem Unterteil 110 verbindbar ist. In dem Oberteil 108 gehen von dessen Oberseite 112 Ausnehmungen 14 aus, in die Halterungen 102 einbringbar sind, die aus einem spangenförmigen eine Auflagefläche 112 bietenden Hauptkörper 114 und von diesem abragende Schenkel 104 und 106 umfaßt. Die Halterung 102 zeigt demzufolge eine C-Form entsprechend der Halterung 12 nach Fig. 5. Die Schenkel 104 und 106 werden von an den Längsseiten 20 bzw. 22 der Ausnehmungen 14 vorhandenen Führungen 24 bzw. 26 aufgenommen, die von parallel zueinander verlaufenden Stegen 25 und 27 begrenzt sind. In der Bodenfläche 29 der Ausnehmung 14 befindet sich jeweils unterhalb der Führung 24 bzw. 26 eine schlitzförmige Aussparung 31 bzw. 33, in das das freie Ende des Schenkels 106 bzw. 104 bei in das Tableau 100 eingebrachter Halterung 102 eingreift. Dabei gelangen die freien Enden der Schenkel 104, 106 in einen Umfang unterhalb der Bodenseite 29 der Ausnehmung 14, daß die in den Seitenrändern 116 bzw. 118 vorhandenen Aussparungen wie Einkerbungen 120, 122 im Bereich zwischen der Ausnehmung 14 und dem Boden 124 mit Schiebe- bzw. Verreigelungselementen 126 wechselwirken können, um wahlweise die Halterung 102 aus der Ausnehmung 14 entfernen zu können oder in dieser zu arretieren. Jedes Verschiebebzw. Verriegelungselement 126, das jeweils einer Ausnehmung 14 zugeordnet ist, wird jeweils aus zwei ineinander übergehende in einem plattenförmigen Element 128 eingelassene Aussparungen 130 und 132 gebildet, deren Übergang durch Vorsprünge 134 und 136 gebildet werden, die mit den Einkerbungen 120, 122 eines der Schenkel 104 bzw. 106 wechselwirken. Ferner weist ein in Längsrichtung der Aussparungen 130, 132 gesehener Außenliegender Randbereich 138 eine stufenförmige Verjüngung auf, wodurch ebenfalls Vorsprünge 140, 142 gebildet werden, die ihrerseits mit den weiteren Einkerbungen des anderen Schenkels 106 bzw. 104 im gewünschten Umfang wechselwirken. Dabei kann das plattenförmige Element 128 derart entlang der Bodenfläche 124 des Tableau 104 verschoben werden, daß die Vorsprünge 134, 136 und 140, 142 in die Einkerbungen 120, 122 der Schenkel 104 und 106 eingreifen. In diesem Fall kann die Halterung 102 nicht mehr aus der Ausnehmung 14 herausgenommen werden. Wird dagegen das plattenförmige Element 128 derart in bezug auf die Ausnehmungen verschoben, daß die freien Enden der Schenkel 104 und 106 ausschließlich innerhalb der Aussparungen 130 und 132 liegen, so können diese durch die erwähnten Vorsprünge nicht mehr behindert werden, so daß die Halterung 102 aus der Ausnehmung 14 entfernbar ist. Im Ausführungsbeispiel nach Fig. 13 muß demzufolge das plattenförmige Element 128, das die als Verriegelung dienenden Schiebeelemente 126 umfaßt, in Richtung des unteren Randes der Zeichnung bewegt werden, um eine Entriegelung zu ermöglichen.

Wie insbesondere an Hand der Fig. 12 und 13 verdeutlicht wird, sind dem plattenförmigen Element 128 entsprechend der Anordnung der Ausnehmungen 14 die die Schiebeelemente 126 bildenden Aussparungen eingelassen, um so im gewünschten Umfang die Ausnehmungen frei zugänglich zu machen oder zu verriegeln.

Insbesondere an Hand der Darstellung der Fig. 13 ist auch erkennbar, daß die Breite der in dem plattenförmigen Element 128 eingelassenen das Schiebe- bzw. Verriegelungselement 126 bildenden Aussparungen 130 und 132 gleich oder größer als die Breite der Schenkel 104 und 106 ist. Nur im Übergangsbereich zwischen den Aussparungen 130 und 132 und in dem außenliegenden Rand der Aussparung 130 erfolgt derart eine Verjüngung, daß die hierdurch gebildeten Vorsprünge 134, 136, 140, 142 in die Einkerbungen 120 und 122 der Schenkel 104 und 106 eingreifen.

Um das plattenförmige die Schiebeelemente 126 aufweisende Element 128 entlang des Bodens 124 im gewünschten Umfang zu verschieben, ragen von diesem Stege 144 und 146 auf, die im Bereich des Verschlußelementes 148 zueinander beabstandet sind. Ein nicht dargestellter von dem Verschlußelement 148 abragender Bügel kann nun wahlweise auf den Steg 144 oder 146 einwirken, um so das Element 128 und damit die Schiebeelemente 126 mit in die Ausnehmungen 14 eingebrachten Halterungen 102 wechselwirken zu lassen oder nicht.

Um den Schenkeln 104 und 106 eine erhöhte Stabilität zu geben, können in deren Längsrichtung Versteifungsrippen 148 verlaufen, wie die Fig. 14 verdeutlicht. Ferner ist erkennbar, daß von den Schenkeln 104 bzw. 106 nach außen abragende Verstärkungen wie linsenförmige Wulste 150 ausgehen, die in in dem Bereich der Führungen 22 und 24 vorhandene Aussparungen 152 eingreifen, wodurch eine Sicherung der Halterung 102 gegen ein unkontrolliertes Herausgleiten bei z.B. Kippen des Tableaus 100 unterbunden werden kann. In der Bodenplatte 110 des Tableaus 100 sind ferner schlitzförmige Aufnahmen 154 angeordnet, in die die freien Enden der Schenkel 104 und 106 einbringbar sind, so daß hierdurch sichergestellt ist, daß die Schenkel 104 und 106 nicht aufeinanderzubewegt werden können. Hierdurch wird die Diebstahlsicherung erhöht.

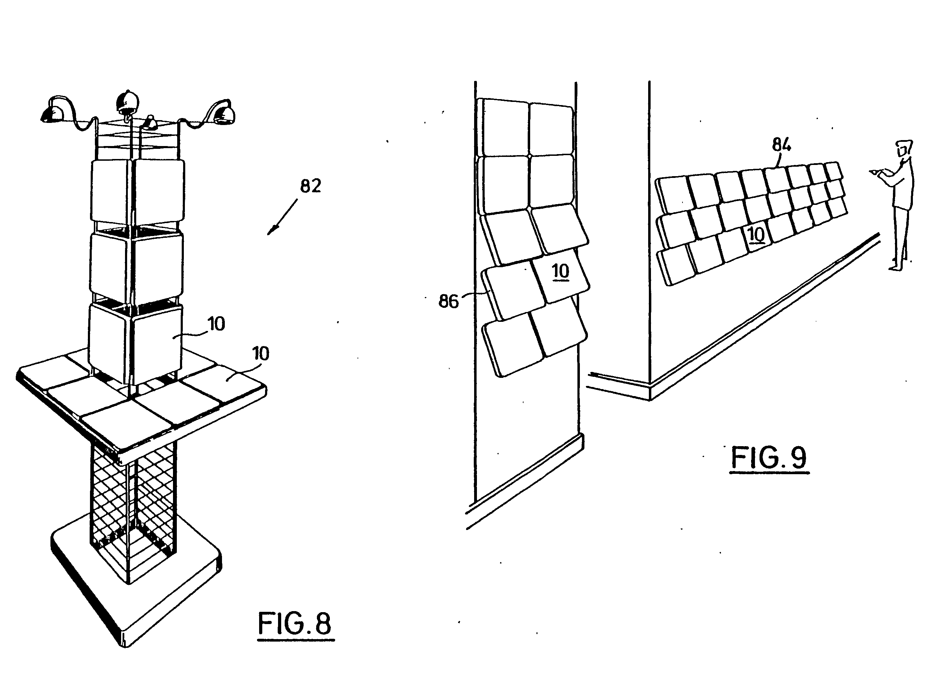

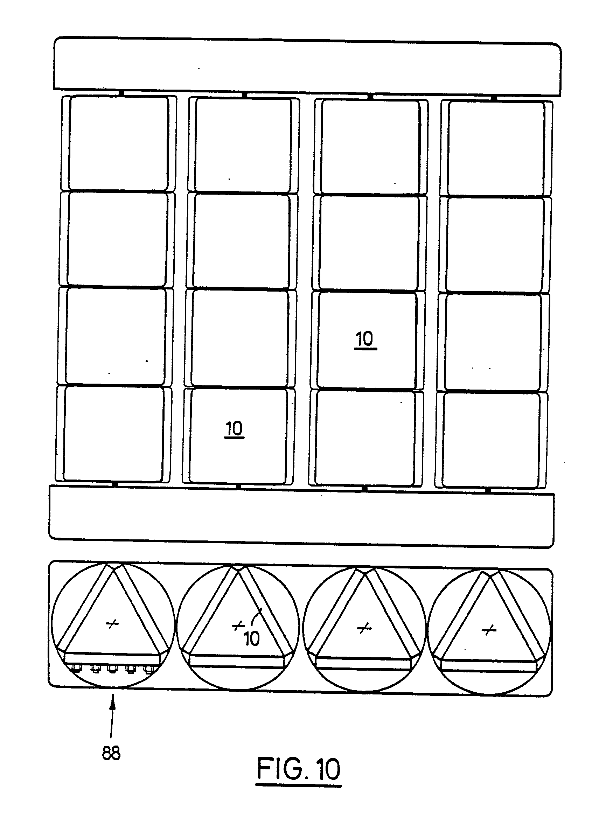

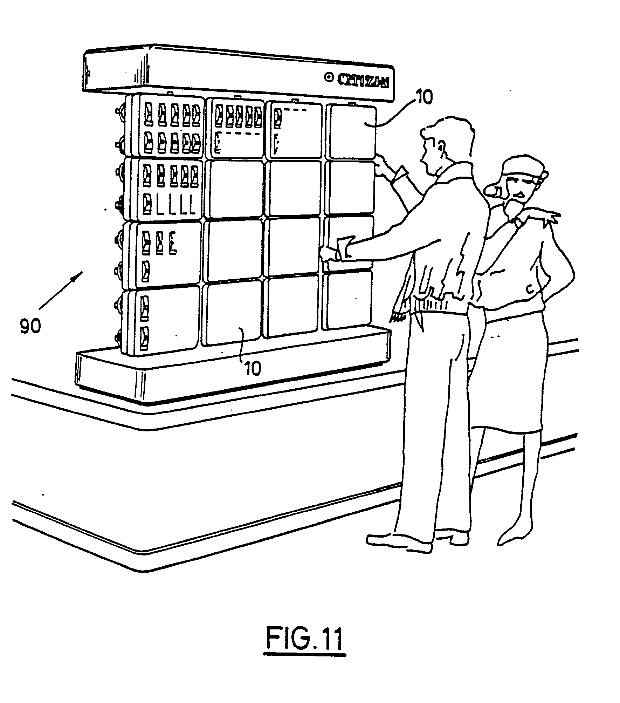

Mehrere der anhand der Fig. 1 bis 7 näher beschriebenen Präsentationskästen 10 und 100 können nun zu Verkaufsständen in Form von z.B. Säulen 82 (Fig. 8), Präsentationswänden 84 und 86 (Fig. 9) bzw. -tafeln 90 (Fig. 11) oder zu drehbar ausgebildeten Prismen 88 (Fig. 10) zusammengestellt werden. Dabei bietet insbesondere die Prismensäulenausbildung gemäß Fig. 10 den Vorteil, daß die Präsentationsfläche durch Drehen der Säulen 88 derart vergrößert werden kann, daß die zur Verfügung stehende Fläche scheinbar verdreifacht wird.

**Patentansprüche**

1. Präsentationskasten in Form eines Präsentationstableaus (10, 100) mit einer Präsentationsfläche zum offenen Anbieten von Gegenständen, wie insbesondere Uhren, mit Halterungen (12, 102), die zumindest in eine von der Präsentationsfläche ausgehende Ausnehmung (14) einbringbar ist, wobei die Gegenstände lösbar mit den Halterungen verbunden sind, die ihrerseits bei in den Ausnehmungen eingebrachter Positionierung gegen ein unkontrolliertes Entfernen dadurch gesichert sind, daß in von den Halterungen ausgehendem Abschnitt (28, 30, 104, 106) eine Sicherung eingreift, und wobei die Sicherung zumindest ein Schiebeelement (16, 42, 44, 54, 126) ist, das parallel oder in etwa parallel zu dem Boden (48, 124) des Präsentationskastens derart verschiebbar ist, daß es wahlweise den Abschnitt (28, 30, 104, 106) zumindest bereichsweise erfaßt, dadurch gekennzeichnet, daß für jede Halterung eine gesonderte von der Präsentationsfläche ausgehende Ausnehmung (14) vorhanden ist, daß jede Halterung (12, 102) zwei zueinander beabstandete von der Rückseite der für einen Gegenstand bestimmten Haltefläche (32, 112) oder von dessen Seitenrändern ausgehende Abschnitte (28, 30, 104, 106) aufweist, daß der Gegenstand auf der Haltefläche und zwischen den von diesen bzw. deren Seitenrändern ausgehenden Abschnitten derart verläuft, daß bei in der Ausnehmung eingebrachter Halterung der Gegenstand von dieser nicht entfernbar ist, und daß jede Ausnehmung (14) zumindest an einer ihrer Innenseiten (20, 22) eine für die einzubringende Halterung (12, 102) bestimmte Führung (24, 26) aufweist, in die einer der beiden von der Haltefläche oder deren Seitenrändern ausgehenden Abschnitte (28, 30, 104, 106) der Halterung geführt ist.

2. Präsentationskasten nach Anspruch 1, dadurch gekennzeichnet, daß jeder Abschnitt (104, 106) ein sich in Richtung des Bodenbereichs (124) erstreckender Schenkel ist, der im Bereich von zumindest einem Längsrand (116, 118) von dem Schiebeelement (126) erfaßbar ist.

3. Präsentationskasten nach Anspruch 2, dadurch gekennzeichnet, daß der vorzugsweise flach ausgebildete Schenkel (104, 106) in seinen Längsrändern (116, 118) Aussparungen (120, 122) wie Einkerbungen aufweist, in die von dem Schiebeelement (126) asugehende Vorsprünge (134, 136, 140, 142) eingreifen.

4. Präsentationskasten nach Anspruch 1, dadurch gekennzeichnet, daß die zwei Abschnitte in Form von Schenkeln (28, 30, 104, 106) jeweils in eine an gegenüberliegenden Innenseiten (20, 22) der Ausnehmung (14) verlaufende Führung (24, 26) einbringbar sind.

5. Präsentationskasten nach Anspruch 1, dadurch gekennzeichnet, daß die Schiebeelemente (126) in einem im Bodenbereich (124) des Präsentationstableau (100) verschiebbaren plattenförmigen Element (128) eingelassen und jeweils durch zwei ineinander übergehende Aussparungen (130, 132) gebildet sind, wobei der Übergangsbereich zwischen diesen und ein in Längsrichtung der Aussparungen gesehener äußerer Randbereich (138) von einer der Aussparungen, die mit den in den Schenkeln (104, 106) vorhandenen Aussparungen (120, 122) wie Kerben wechselwirkenden Vorsprünge (134, 136, 140, 142) aufweisen.

6. Prasentationskasten nach Anspruch 5, dadurch gekennzeichnet, daß die Breite der Aussparungen (130, 132) außerhalb der in der Ebene des plattenförmigen Elementes (128) verlaufenden Vorsprünge (134, 136, 140, 142) größer als die Breite der Schenkel (104, 106) ist.

7. Präsentationskasten nach Anspruch 1, dadurch gekennzeichnet, daß das Präsentationstableau (100) mehrere vorzugsweise in Reihe angeordnete Halterungen (102) aufnehmende Ausnehmungen (14) aufweist, wobei die in diese eingebrachte Halterungen durch Verschieben des plattenförmigen Elementes (128) gleichzeitig lösbar oder verriegelt sind.

8. Präsentationskasten nach Anspruch 1, dadurch gekennzeichnet, daß jedes Schiebeelement ein seitlich abragendes stabförmiges Element (16, 42, 44) umfaßt, das jeweils einer in dem Präsentationstableau eingebrachten Halterung (12) zugeordnet ist.

9. Präsentationskasten nach Anspruch 8, dadurch gekennzeichnet, daß das Präsentationstableau (10) vorzugsweise Quaderform mit den vorzugsweise in Reihe angeordneten von der Oberseite (62) zugänglichen die Halterungen (12) aufnehmenden Ausnehmungen (14) aufweist, wobei jede Ausnehmung zumindest an einer Innenseite (20, 22) eine Führung (24, 26) für einen von der Halterung ausgehenden Abschnitt (28, 30) umfaßt.

10. Präsentationskasten nach Anspruch 9, dadurch gekennzeichnet, daß bei in das Präsentationstableau (10) eingebrachter Halterung (12) der in der Führung (24, 26) verlaufende Abschnitt (28, 30) der Halterung von dem freien Ende (42) des dieser zugeordneten stabförmigen Elementes (16) durchsetzt ist.

11. Präsentationskasten nach Anspruch 4 oder 10, dadurch gekennzeichnet, daß die gegenüberliegenden in Längsrichtung der Ausnehmung (14) verlaufenden Innenseiten (20, 22) jeweils eine Führung (24, 26) aufweisen, in die die parallel zueinander verlaufenden und von einer für den Gegenstand bestimmten Auflagefläche (32) der Halterung (12) oder von dessen Unterseite ausgehenden Abschnitte (28, 30) eingreifen.

12. Präsentationskasten nach Anspruch 1, dadurch gekennzeichnet, daß von dem Innenboden (48) parallel zueinander in Verschieberichtung des Schiebeelementes (54) verlaufende Stege (56, 58) ausgehen, die in vorzugsweise nutenförmig ausgebildete Längsaussparungen (50, 52) der Schiebeelemente (54) eingreifen.

13. Präsentationskasten nach Anspruch 10, dadurch gekennzeichnet, daß die stabförmigen die Halterungen (12) erfassenden Elemente (16, 42, 44) von einer die Längsaussparungen (50, 52) aufweisenden Grundplatte (46) ausgehen, die ihrerseits zum Festlegen ihrer Position mit einem Verschlußelement (72) wechselwirkt.

14. Präsentationskasten nach Anspruch 5, dadurch gekennzeichnet, daß das plattenförmige die durch die Aussparungen (130, 132) gebildeten Verschiebeelemente (126) aufweisende Element (128) zum Festlegen seiner Position mit einem vorzugsweise von der Oberseite (112) des Präsentationstableau (100) betätigbaren Verschlußelement (148) wechselwirkt.

15. Präsentationskasten nach Anspruch 10, dadurch gekennzeichnet, daß die freien Enden (42) der stabförmigen Elemente (16) parallel zur Verschieberichtung des Schiebeelementes (54) verlaufen und in von der Bodenplatte (48) ausgehenden im Bereich zwischen den von der Oberseite sich in das Innere des Präsentationstableau (10) erstreckenden Ausnehmungen (14) angeordneten Lagerelementen (64, 68) geführt sind.

16. Präsentationskasten nach Anspruch 10, dadurch gekennzeichnet, daß die Längsachse des freien Endes (42) zu der Längsachse des von der Grundplatte (46) ausgehenden Abschnitts (44) des stabförmigen Elements (16) in Richtung der Bodenplatte (48) versetzt verläuft.

17. Präsentationskasten nach Anspruch 1 bestimmt für Uhren, dadurch gekennzeichnet, daß die Halterungen (12, 102) spangenförmig ausgebildet und von den Uhren umgeben sind und daß die die Abschnitte (28, 30) erfassenden Schiebelemente (54, 126) zu deren Verschiebung entlang der Bodenplatte von einem plattenförmigen Element (46, 128) ausgehen bzw. in diesem eingelassen sind, das seinerseits zu dessen Positionierung mit einem Verschlußelement (18, 148) wechselwirkt.

18. Präsentationskasten nach Anspruch 17, dadurch gekennzeichnet, daß das Schiebeelement (16, 42, 44, 126) durch ein stabförmiges zumindest einen als Schenkel ausgegebildeten Abschnitt (28, 30, 104, 106) der Halterung (12, 102) durchsetzendes Element oder durch zwei in dem plattenförmigen Element (128) eingelassene und ineinander übergehende Aussparungen (130, 132) gebildet ist.

19. Präsentationskasten mit für die Aufnahme einer Halterung von z.B. einer Uhr vorgesehener Ausnehmung, nach zumindest Anspruch 1 oder Anspruch 9, dadurch gekennzeichnet, daß die Halterung (12, 102) über von dieser ausgehende Abschnitte (28, 30, 104, 106) in in gegenüberliegenden Seitenflächen (20, 22) der Ausnehmung (14) angeordnete Führungen (24, 26) eingebracht ist, daß die freien Enden der Abschnitte in in der Bodenfläche (29) der Ausnehmung vorhandene schlitzförmige Aussparungen (31, 33) eingreifen und daß die Abschnitte jeweils einen sich in Richtung der angrenzenden Seitenfläche (20, 22) erstreckenden Vorsprung (39, 150) aufweist, der in eine in der Seitenfläche vorhandene Aussparung (41, 152) zumindest teilweise eingreift.

20. Präsentationskasten nach Anspruch 19, dadurch gekennzeichnet, daß der Vorsprung (39, 150) linsenförmig ist.

**Revendications**

1. Boîte de présentation prévue sous la forme d'un tableau de présentation (10, 100) avec une surface de présentation pour l'offre à découvert d'objets, notamment de montres, avec supports (12, 102) logeables dans au moins un évidement (14) partant de la surface de présentation, les objets étant liés aux supports tout en pouvant être détachés, supports qui euxmêmes sont, après positionnement dans les évidements, protégés contre un enlèvement incontrôlé en ce qu'une sûreté s'engage dans la section (28, 30, 104, 106) partant des supports, la sûreté étant au minimum un élément coulissant (16, 42, 44, 54, 126) susceptible d'être déplacé parallèlement ou à peu près parallèlement au fond (48, 124) de la boîte de présentation de telle manière qu'il couvre, au moins par zones, la section (28, 30, 104, 106), caractérisé en ce qu'existe pour chaque support un évidement (14) particulier partant de la surface de présentation, en ce que chaque support (12, 102) présente deux sections (28, 30, 104, 106), éloignées l'une de l'autre et partant de la face arrière de la surface de maintien (32, 112) destinée à un objet, ou de ses bords latéraux, en ce que l'objet suit un tracé, sur la surface de maintien et entre les sections partant de celle-ci ou de ses bords latéraux, tel que, après mise en place du support dans l'évidement, l'objet ne peut être éloigné de ce dernier et que chaque évidement (14) présente au minimum, sur l'une de ses faces intérieures (20, 22), une glissière (24, 26) destinée au support (12, 102) à mettre en place, glissière servant à guider l'une des deux sections (28, 30, 104, 106) du support, qui part de la surface de maintien ou de ses bords latéraux.

2. Boîte de présentation suivant la revendication no. 1, caractérisée en ce que chaque section (104, 106) est une aile s'étendant vers la zone du fond (124), aile qui peut être saisie par l'élément coulissant (126) dans la zone d'au moins un bord longitudinal (116, 118).

3. Boîte de présentation suivant la revendication no. 2, caractérisée en ce que l'aile (104, 106), ayant de préférence une forme plate au niveau de ses bords longitudinaux (116, 118), présente des évidements (120, 122), tels que rainures, dans lesquels s'engagent des saillies (134, 136, 140, 142) partant de l'élément coulissant 126).

4. Boîte de présentation suivant la revendication no. 1, caractérisée en ce que les deux sections, prévues sous forme d'ailes (28, 30, 104, 106), peuvent être mises en place dans une glissière (24, 26) prévue sur les faces intérieures opposées (20, 22) de l'évidement (14).

5. Boîte de présentation suivant la revendication no. 1, caractérisée en ce que les éléments coulissants (126) sont encastrés dans un élément, en forme de plaque et déplaçable au niveau du fond (124) du tableau de présentation (100), et formés chacun par deux évidements (130, 132) se trouvant en contact, auquel cas la zone de contact entre ceux-ci et la zone marginale extérieure (138) de l'un de ces évidements, vue dans le sens de la longueur des évidements, forme avec les évidements (120) ménagés dans les ailes (104, 106) des saillies (134, 136, 140, 142) interagissant comme des entailles.

6. Boîte de présentation suivant la revendication no. 5, caractérisée en ce que la largeur des évidements (130, 132) est supérieure à la largeur des ailes (104, 106) à l'extérieur des saillies (134, 136, 140, 142) prévues sur le plan de l'élément (128) en forme de plaque.

7. Boîte de présentation suivant la revendication no. 1, caractérisée en ce que le tableau de présentation (100) présente plusieurs évidements (14) recevant plusieurs supports (102) disposés de préférence en rangée, les supports encastrés dans ceux-ci pouvant être détachés ou verrouillés simultanément par déplacement de l'élément en forme de plaque (128).

8. Boîte de présentation suivant la revendication no. 1, caractérisée en ce que chaque élément coulissant comprend un élément en forme de barre faisant saillie sur le côté (16, 42, 44), élément qui est chaque fois affecté à un support (12) encastré dans le tableau de présentation.

9. Boîte de présentation suivant la revendication no. 8, caractérisée en ce que le tableau de présentation (10) présente de préférence une forme carrée avec les évidements (14) recevant les supports (12) disposés de préférence en rangée et accessibles par la partie supérieure (62), chaque évidement comprenant, au minimum sur une face intérieure (20, 22), une glissière (24, 26) destinée à une section (28, 30) partant du support.

10. Boîte de présentation suivant la revendication no. 9, caractérisée en ce que, sur le support (12) incorporé dans le tableau de présentation (10), la section (28, 30) du support, prévue dans la glissière (24, 26), est traversée par l'extrémité libre (42) de l'élément en forme de barre (16) affecté au support.

11. Boîte de présentation suivant la revendication no. 4 ou 10, caractérisée en ce que les faces intérieures (20, 22) opposées orientées dans le sens de la longueur de l'évidement (14) présentent chacune une glissière (24, 26) dans laquelle s'engagent les sections (28, 30) parallèles entre elles et partant d'une surface d'appui (32) du support (12), destinée à l'objet, ou de sa face inférieure.

12. Boîte de présentation suivant la revendication no. 1, caractérisée en ce que du fond intérieur (48) partent des traverses (56, 58) parallèles entre elles et orientées dans le sens de déplacement de l'élément coulissant (54), traverses qui s'engagent dans des évidements longitudinaux (50, 52), conçus de préférence en forme de rainures, des éléments coulissants (54).

13. Boîte de présentation suivant la revendication no. 10, caractérisée en ce que les éléments (16, 42, 44) en forme de barre saisissant les supports (12) partent d'une plaque d'assise présentant les évidements longitudinaux (50, 52), plaque qui elle-même interagit, pour la fixation de sa position, avec un élément de fermeture (72).

14. Boîte de présentation suivant la revendication no. 10, caractérisée en ce que l'élément en forme de plaque (128), présentant les éléments coulissants (126) formés par les évidements (130, 132), interagit, pour la fixation de sa position, avec un élément de fermeture (148) actionnable de préférence depuis la partie supérieure (112) du tableau de présentation (100).

15. Boîte de présentation suivant la revendication no. 10, caractérisée en ce que les extrémités libres (42) des éléments en forme de barre (16) suivent un tracé parallèle au sens de déplacement de l'élément coulissent (54) et sont guidées par des éléments de palier (64, 68) partant de la plaque de fond (48) et disposés dans la zone comprise entre les évidements (14) qui s'engagent dans la partie intérieure du tableau de présentation (10).

16. Boîte de présentation suivant la revendication no. 10, caractérisée en ce que l'axe longitudinal de l'extrémité libre (42) est décalé par rapport à l'axe longitudinal de la section (44), qui part de la plaque d'assise (46), de l'élément en forme de barre (16) en direction de la plaque d'assise (48).

17. Boîte de présentation suivant la revendication no. 1, caractérisée en ce que les supports (12, 102) ont la forme de boucles et sont entourés par les montres, et en ce que les éléments coulissants (54, 126) saisissant les sections (28, 30) partent d'un élément en forme de plaque (46, 128) pour leur déplacement le long de la plaque de fond ou sont encastrés dans celui-ci qui, quant à lui, interagit avec un élément de fermeture (18, 148) pour son positionnement.

18. Boîte de présentation suivant la revendication no. 17, caractérisée en ce que l'élément coulissant (16, 42, 44, 126) est formé par un élément en forme de barre traversant au minium une section (28, 30, 104, 106), conçue comme aile, du support (12, 102) ou par deux évidements ménagés dans l'élément (128) en forme de plaque et se trouvant en contact.

19. Boîte de présentation avec un évidement prévu pour la réception d'un support, d'une montre par exemple, suivant au moins la revendication 1 ou la revendication 9, caractérisée en ce que le support (12, 102) est, via des sections (28, 30, 104, 106) partant de celui-ci, logé dans des glissières (24, 26) disposées dans des faces latérales (20, 22) opposées de l'évidement (14), en ce que les extrémités libres des sections s'engagent dans des évidements (31, 33) en forme de fentes et prévus au fond (29) de l'évidement et en ce que les sections présentent chacune une saillie (39, 150) s'étendant en direction de la face latérale limitrophe (20, 22), saillie qui s'engage, au moins partiellement, dans un évidement (41, 152) présent dans la face latérale.

20. Boîte de présentation suivant la revendication no. 19, caractérisée en ce que la saillie (39, 150) a la forme d'une lentille.

**Claims**

1. Presentation case in the shape of a presentation panel (10, 100) with a presentation surface for the open display of objects such as watches, with holding devices (12, 102), which can at least be mounted in a recess (14) projecting from the presentation surface, whereby the objects are removably connected with the holding devices, which themselves are secured in the recess arranged for positioning purposes against uncontrollable removal, that a locking device engages in a segment (28, 30, 104, 106) emanating from the holding device, and whereby the locking device is at least one sliding element (16, 42, 44, 54, 126), which is movable parallel or about parallel to the bottom (48, 124) of the presentation case, that it optionally grips the segments (28, 30, 104, 106) at least area-wise characterized in that for each holding device a separate recess (14) projecting from the presentation case is available, that each holding device (12, 102) has two segments distanced to each other, said segments (28, 30, 104, 106) project from the rear or from the lateral edges of the holding surface to hold an object, that the object is arranged on the holding surface and between the segments emanating from this surface resp. its lateral edges in such a manner, that the object cannot be removed from the holding device in the recess, and that each recess (14) at least at one of its inner surfaces (20, 22) has a guideway (24, 26) adopted to bring in the holding device, into which one of the two segments (28, 30, 104, 106) projecting from the display surface or its side edges is guided to the holding device.

2. Presentation case according to Claim 1, characterized in that each segment (104, 106) has the form of a leg extending towards the bottom section (124), said leg can be gripped in the region of at least one long edge (116, 118) by the sliding element (126).

3. Presentation case according to Claim 2, characterized in that the preferably flat-shaped leg (104, 106) has recesses (120, 122) such as notches in its long edges (116, 118) into which projections (134, 136, 140, 142) from the sliding element (126) engage.

4. Presentation case according to Claim 1, characterized in that the two segments in the shape of legs (28, 30, 104, 106) respectively are fed into guideways (24, 26) running along on the opposite inner sides (20, 22) of the recess (14).

5. Presentation case according to Claim 1, characterized in that the sliding elements (126) are let into a slidable plate-shaped element (128) in the bottom section (124) of the presentation case (100), and are formed by two cutouts (130, 132) transitioning into each other. Hereby the transition region between the two said cutouts and one extreme edge area (138) thereof—as seen along the longitudinal axis of these cutouts—has projections (134, 136, 140, 142) which interact with features (120, 122) such as notches in the legs (104, 106).

6. Presentation case according to Claim 5, characterized in that the width of the cutouts (130, 132) outside the projections (134, 136, 140, 142) in the plane of the plate-shaped element (128) is bigger than the width of the legs (104, 106).

7. Presentation case according to Claim 1, characterized in that the presentation panel (100) has several recesses (14) for display holders (120) preferably arranged in rows, whereby the display holders fitted therein are simultaneously released or locked by shifting the plate-shaped element (128).

8. Presentation case according to Claim 1, characterized in that each sliding element includes a laterally projecting rod-shaped element (16, 42, 44) each allocated to one display holder (12) fitted in the presentation panel.

9. Presentation case according to Claim 8, characterized in that the presentation panel (10), preferably in rectangular block form, has recesses (14) with the display holders (12) accessibly arranged preferably in rows on the top side (62), whereby each recess includes a guide (24, 26) at least on one internal side (20, 22) for a segment (28, 30) projecting from the display holder.

10. Presentation case according to Claim 9, characterized in that when a display holder (12) is fitted in the presentation panel (10), the free end (42) of the segment (28, 30) of said display holder running in the guide (24, 26) is penetrated by the rod-shaped element (16) associated with it.

11. Presentation case according to Claim 4 or 10, characterized in that the opposite longitudinal internal sides (20, 22) of the recess (14) each have a guide (24, 26) into which engage the mutually parallel segments (28, 30) projecting down from the supporting surface (32) intended to carry an object on the display holder (12), or from the underside thereof.

12. Presentation case according to Claim 1, characterized in that webs (56, 58) project parallel to one another from the inside base (48) and run in the direction in which the sliding element (54) moves, and which engage preferably in slot-shaped longitudinal recesses (50, 52) in said sliding element (54).

13. Presentation case according to Claim 10, characterized in that the rod-shaped elements (16, 42, 44) which interact with the display holders (12), project from a base plate (46) with the longitudinal recesses (50, 52), which in turn interact with a locking element (72) to fix their position.

14. Presentation case according to Claim 5, characterized in that a plate-shaped element (128) with the sliding elements (126) formed by the cutouts (130, 132), which, to determine its position, interacts with a locking element (148) preferably operable from the upper side (112) of the presentation panel (100).

15. Presentation case according to Claim 10, characterized in that the free ends (42) of the rod-shaped elements (16) run parallel to the direction of motion of the sliding element (54), and are guided in bearing elements (64, 68) projecting from the bottom plate (48) into the space between it and the recesses (14) extending down from the top side into the interior of the presentation panel (10).

16. Presentation case according to Claim 10, characterized in that the longitudinal axis of the free end (42) of segment (44) of the rod-shaped element (16) projecting at right angles relative to the longitudinal axis of the base plate (46) is offset towards the bottom plate (58).

17. Presentation case according to Claim 1 appointed for watches, characterized in that the holding devices (12, 102) have the shape of a bracelet and are encompassed by the watches and that the sliding elements (54, 126) gripping the segments (28, 30) are shifted along the bottom plate projecting from the plate-shaped element (46, 128) or are inserted in it, said element in turn interacts with a locking device (18, 148) for positioning purposes.

18. Presentation case according to Claim 17, characterized in that the sliding element (16, 42, 44, 126) takes the form of a rod-shaped element passing through at least one leg-like segment (28, 30, 104, 106) of the display holder (12, 102), or of two mutually interconnected cutouts (130, 132) let into the plate-shaped element (128).

19. Presentation case provided with the recess to take a display holder, e.g., for a wrist watch, at least according to Claim 1 or Claim 9, characterized in that the display holder (12, 102) is mounted via segments (28, 30, 104, 106) projecting therefrom in guideways (24, 26) arranged in mutually opposite side walls (20, 22) of the recess (14), the free ends of said segments engaging into slot-shaped openings (31, 33) in the bottom (29) of the recess, and that said segments each exhibit a projection (39, 150) extending towards the adjacent side wall (20, 22), and which engages at least partially into the opening (41, 152) in said side wall.

20. Presentation case according to Claim 19, characterized in that the projection (39, 150) is lentiform.

FIG.1

FIG.7

FIG.5

FIG.4

FIG.3

FIG.2

68

70

64

58

56

48

# FIG.6

82

10

10

**FIG. 8**

84

86

10

10

**FIG. 9**

EP 0 265 423 B1

FIG.10

FIG.11

FIG.12

7

FIG.14

FIG.13